Europäisches Patentamt

European Patent Office

Office européen des brevets

(11) Publication number: **0 617 510 A1**

(12) **EUROPEAN PATENT APPLICATION**

(21) Application number: **94104438.0**

(22) Date of filing: **21.03.94**

(51) Int. Cl.⁵: **H03H 9/42, G06G 7/195**

(30) Priority: **22.03.93 JP 85134/93**
**09.03.94 JP 38254/94**

(43) Date of publication of application:
**28.09.94 Bulletin 94/39**

(84) Designated Contracting States:
**DE FR GB IT NL**

(71) Applicant: **CANON KABUSHIKI KAISHA**
**30-2, 3-chome, Shimomaruko,**
**Ohta-ku**
**Tokyo (JP)**

(72) Inventor: **Eguchi, Tadashi, c/o Canon**
**Kabushiki Kaisha**
**30-2, 3-chome,**
**Shimomaruko**
**Ohta-ku, Tokyo 146 (JP)**
Inventor: **Torisawa, Akira, c/o Canon**
**Kabushiki Kaisha**
**30-2, 3-chome,**
**Shimomaruko**
**Ohta-ku, Tokyo 146 (JP)**
Inventor: **Mochizuki, Norihiro, c/o Canon**
**Kabushiki Kaisha**

**30-2, 3-chome,**
**Shimomaruko**
**Ohta-ku, Tokyo 146 (JP)**
Inventor: **Egara, Koichi, c/o Canon Kabushiki**
**Kaisha**
**30-2, 3-chome,**
**Shimomaruko**
**Ohta-ku, Tokyo 146 (JP)**
Inventor: **Koyama, Akihiro, c/o Canon**
**Kabushiki Kaisha**
**30-2, 3-chome,**
**Shimomaruko**
**Ohta-ku, Tokyo 146 (JP)**
Inventor: **Hachisu, Takahiro, c/o Canon**
**Kabushiki Kaisha**
**30-2, 3-chome,**
**Shimomaruko**
**Ohta-ku, Tokyo 146 (JP)**

(74) Representative: **Tiedtke, Harro, Dipl.-Ing. et al**
**Patentanwaltsbüro**
**Tiedtke-Bühling-Kinne & Partner**
**Bavariaring 4**
**D-80336 München (DE)**

(54) **Surface acoustic wave element for coupling surface acoustic wave with waveguide at high efficiency, method for designing it, and signal receiver and communication system using it.**

(57) A surface acoustic wave element includes a piezoelectric substrate (10), a waveguide (14) provided on the piezoelectric substrate to guide a surface acoustic wave therethrough, and an input transducer (11) provided on said piezoelectric substrate to generate the surface acoustic wave. The input transducer is arranged to concentrate the surface acoustic wave so as to couple it with the waveguide and to oscillate the surface acoustic wave within a range of an aperture angle of the waveguide.

FIG. 2

## BACKGROUND OF THE INVENTION

### Field of the Invention

The present invention relates to a surface acoustic wave (SAW) element such as a SAW convolver used in spread spectrum communication, a method for designing it, and a signal receiver and a communication system using it.

### Related Background Art

The SAW element, particularly a SAW convolver for extracting a convolution signal of two SAW signals, has been increasingly important in recent years and studied actively as a key device in making the spread spectrum communication.

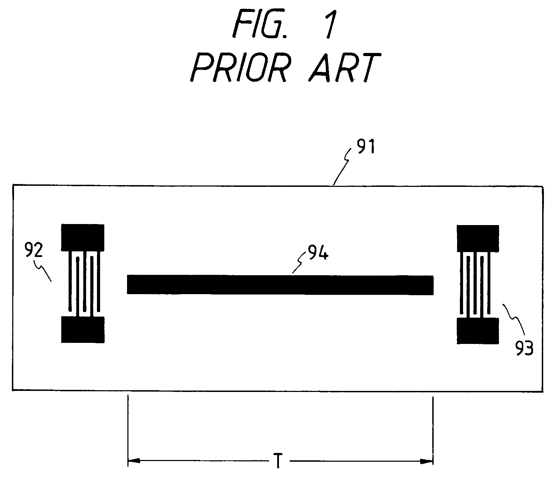

Fig. 1 is a schematic drawing to show an example of a conventional SAW element of this type. In Fig. 1, reference numeral 91 designates a piezoelectric substrate made for example of Y-cut (Z-propagating) lithium niobate, 92, 93 input interdigital transducer (referred to as IDT) as input transducers formed on the surface of the piezoelectric substrate 91, and 94 an output electrode formed on the surface of the piezoelectric substrate 91. These electrodes are made of a conductive material such as aluminum and usually formed utilizing the photolithography technology.

When an electric signal with carrier angular frequency $\omega$ is input into the input IDT 92 in the SAW element as so arranged, the piezoelectric effect of the substrate oscillates a surface acoustic wave. Similarly, when an electric signal with carrier angular frequency $\omega$ is input into the input IDT 93, the piezoelectric effect of the substrate oscillates a surface acoustic wave. These two surface acoustic waves propagate in mutually opposite directions on the piezoelectric substrate 91 between the two input electrodes 92 and 93, and a convolution signal (carrier angular frequency $2\omega$), which is a correlation output of the two input signals, can be taken out from the output electrode 94 by the physical nonlinear effect of the piezoelectric substrate.

Suppose the x axis is taken along the direction connecting between the two input IDT 92 and 93, the origin is at the middle between the two input IDT 92 and 93, and the two surface acoustic waves are expressed as F(t-x/v)exp{j($\omega$t-kx)} and G(t+x/v)exp{j($\omega$t+kx)}. Then, the nonlinear interaction produces a surface acoustic wave of their product of F(t-x/v)•G(t+x/v)exp(2j$\omega$t) independent of the position, on the piezoelectric substrate 91. Providing a uniform output electrode 94, this signal can be integrated within a region of length of the electrode. Letting T be a length of interaction region, an output single can be expressed as follows.

$$S(t)=Kexp(2j\omega t)\int_{T/2}^{T/2} F(t-x/v)\cdot G(t+x/v)dx \qquad (1)$$

Here, the integration range can be considered substantially between $-\infty$ and $+\infty$ if the interaction region length T is substantially larger than the signal length. Putting $\tau$ = t-x/v into the above formula (1), the following formula is obtained.

$$S(t)=-vKexp(2j\omega t)\int_{-I}^{I} F(\tau)\cdot G(2t-\tau)d\tau \qquad (2)$$

(In the above formula, I in the integration range represents $\infty$.) The resultant single is a convolution of the two SAW input signals. The mechanism of such convolution is described in detail for example in SHIBAYAMA, "Applications of surface acoustic wave," TELEVISION, 30, 457 (1976).

As described above, the SAW convolver is arranged as shown in Fig. 1 to obtain a convolution output signal of a detected signal and a reference signal. The output electrode 94 of Fig. 1 also serves as a waveguide. Namely, vapor deposition of a metal thin film onto a material having the piezoelectric effect provides a waveguide utilizing the concentration effect of surface acoustic waves therein because of a decrease in propagation velocity thereof in that portion, and the concentration effect of surface acoustic waves because of a mass load of vapor-deposited metal.

The convolution efficiency is proportional to the square of energy density. Thus, the output electrode working as waveguide is designed considering a desire to make the width as narrow as possible within the range where the convolution output can be take out, in order to avoid higher propagation transverse modes so as to increase the energy density, and the point that decreasing the width of waveguide increases the velocity change depending upon the frequency. Therefore, letting $\lambda$ be the wavelength of propagating surface acoustic waves, the appropriate width is about 1.5 to $4\lambda$ for Z-propagation convolver of Y-cut lithium niobate.

On the other hand, in order to increase the ratio (coupling efficiency) at which the energy of surface acoustic waves produced therein is guided into the waveguide, the input IDT for converting an electric signal into a SAW signal has been improved such that the shape of the input electrodes as the input IDT is made to be an arc-shape or means for concentrating surface acoustic waves such as a horn or the like is provided between the input transducer and the output electrode as the wave guide.

However, the piezoelectric substrate used for these purposes is often made of a material such as lithium niobate having a large electro-mechanical coupling coefficient for enhancing the efficiency, but also having velocity anisotropy, that is, angle dependency that the phase velocity of surface acoustic waves differs depending upon the propagation direction. In that case, it is difficult to design the input transducer, the waveguide, or the means for concentrating the surface acoustic waves such as the horn. In the conventional devices no consideration was thus given on an aperture angle of waveguide in setting a propagation angle or a wavefront angle of SAW components excited by the input electrodes, which caused a problem of not permitting a high coupling efficiency to be obtained. Also, in case of the means such as the horn for concentrating the surface acoustic waves, no consideration was given on the aperture angle of waveguide in setting a wavefront angle of SAW components changing their angles at the border of horn, which also caused a problem of not permitting a high coupling efficiency to be attained. In contrast, there is a case of designing the device, taking the aperture angle into consideration in determining the entrance shape of waveguide: "MANAS K. ROY, IEEE Transactions on sonics and ultrasonics, vol. su-23, No. 4, July 1976, p.276-". This technique is, however, not suitable for the convolver in that the anisotropy of piezoelectric substrate is not taken into consideration and in that the guided mode and the convolution efficiency of waveguide near the entrance of waveguide are different from those in a portion after full propagation in waveguide because the waveguide width spreads near the waveguide.

Here, the aperture angle of waveguide means an angle of divergence at which a component with a maximum angle of direction of phase velocity with respect to the waveguide direction among surface acoustic waves which can propagate in the waveguide, is output from the waveguide and propagates. In case the direction of the component output from the waveguide and then propagating is symmetric with respect to the waveguide direction, the aperture angle is a double of an angle relative to the waveguide direction at which the component with the maximum angle of direction of phase velocity is output from the waveguide and propagating. The waveguide direction means the propagation direction of surface acoustic wave in the waveguide.

## SUMMARY OF THE INVENTION

It is, therefore, an object of the present invention to provide a surface acoustic wave element which can effectively guide a surface acoustic wave oscillated by an input transducer to a waveguide and which can couple the surface acoustic wave with the waveguide, a method for designing it, a signal receiver using it, and a communication system using it.

The present invention provides a surface acoustic wave element achieving the above object, which comprises:

a piezoelectric substrate;

a waveguide provided on said piezoelectric substrate, for guiding a surface acoustic wave therethrough; and

an input transducer provided on said piezoelectric substrate, for generating the surface acoustic wave, wherein said input transducer is arranged to concentrate the surface acoustic wave thus generated so as to couple the surface acoustic wave with said waveguide, and to oscillate the surface acoustic waves within a range of an aperture angle of said waveguide.

Further, the invention provides a surface acoustic wave element comprising:

a piezoelectric substrate;

a waveguide provided on said piezoelectric substrate, for guiding a surface acoustic wave therethrough;

and

an input transducer provided on said piezoelectric substrate, for generating the surface acoustic wave, wherein said input transducer is an interdigital electrode which is concave toward said waveguide, and wherein a maximum value of angle between a normal line to said interdigital electrode and a waveguide direction is arranged within an angle between the waveguide direction and a normal line to a wavefront of a surface elastic wave output from the waveguide and propagating on the piezoelectric substrate, with a maximum angle of direction of phase velocity relative to the waveguide direction among surface acoustic waves which can propagate in said waveguide.

Further, the invention provides a surface acoustic wave element comprising:

a piezoelectric substrate;

a waveguide provided on said piezoelectric. substrate, for guiding a surface acoustic wave therethrough;

an input transducer provided on said piezoelectric substrate, for generating the surface acoustic wave; and

means for concentrating the surface acoustic wave, provided between said input transducer and said waveguide to concentrate the surface acoustic wave generated by the input transducer so as to couple said wave with the waveguide, wherein said means is arranged such that an angle of propagation of a component in a surface acoustic wave bent by said means is within a range of an aperture angel of said waveguide.

Further, the invention provides a surface acoustic wave element comprising:

a piezoelectric substrate;

a waveguide provided on said piezoelectric substrate, for guiding a surface acoustic wave therethrough;

an input transducer provided on said piezoelectric substrate, for generating the surface acoustic wave; and

means for concentrating the surface acoustic wave, provided between said input transducer and said waveguide to concentrate the surface acoustic wave generated by the input transducer so as to couple said wave with the waveguide, wherein said means is arranged such that a maximum value of an angle between a waveguide direction and a normal line to a wavefront of a surface acoustic wave a direction of which is changed by said means is within an angle between the waveguide direction and a normal line to a wavefront of a surface acoustic wave output from the waveguide and propagating on the piezoelectric substrate, with a maximum angle of direction of phase velocity relative to the waveguide direction among surface acoustic waves which can propagate in said waveguide.

Further, the invention provides a method for designing an input transducer for a surface acoustic wave element in which the input transducer is provided on a piezoelectric substrate to generate a surface acoustic wave and to concentrate said surface acoustic wave so as to couple said wave with a waveguide, comprising steps of:

obtaining a guided mode of said waveguide;

calculating a maximum angle of divergence when said guided mode is output from said waveguide; and

determining a shape of the input transducer such that a surface acoustic wave is oscillated within a range of said maximum angle of divergence and that said surface acoustic wave is concentrated to be coupled with the waveguide.

Further, the invention provides a method for designing means for concentrating a surface acoustic wave in a surface acoustic wave element in which an input transducer is provided on a piezoelectric substrate to generate a surface acoustic wave and said surface acoustic wave is guided to a waveguide through the means for concentrating the surface acoustic wave, comprising steps of:

obtaining a guided mode of said waveguide;

calculating a maximum angle of divergence when said guided mode is output from said waveguide; and

determining a shape of the means for concentrating the surface acoustic wave such that a surface acoustic wave output from the means for concentrating the surface acoustic wave is within a range of said maximum angle of divergence.

Further, the invention provides a signal receiver comprising:

a code generator for generating a reference signal;

a surface acoustic wave element for outputting a convolution signal of a received signal and the reference signal; and

a circuit for demodulating data using the convolution signal output from the surface acoustic wave element;

wherein said surface acoustic wave element comprises:

a piezoelectric substrate;

a waveguide provided on said piezoelectric substrate, for guiding a surface acoustic wave therethrough; and

a first input transducer provided on said piezoelectric substrate to generate a first surface acoustic wave corresponding to the received signal, and a second input transducer for generating a second surface acoustic wave corresponding to the reference signal; and

wherein at least one of said first and second input transducers is arranged to concentrate a generated surface acoustic wave so as to couple said wave with the waveguide and to oscillate a surface acoustic wave in a range of an aperture angle of said waveguide.

Further, the invention provides a signal receiver comprising:

a code generator for generating a reference signal;

a surface acoustic wave element for outputting a convolution signal of a received signal and the reference signal; and

a circuit for demodulating date using the convolution signal output form the surface acoustic wave element;

wherein said surface acoustic wave element comprises:

a piezoelectric substrate;

a waveguide provided on said piezoelectric substrate, for guiding a surface acoustic wave therethrough;

a first input transducer provided on said piezoelectric substrate to generate a first surface acoustic wave corresponding to the received signal, and a second input transducer for generating a second surface acoustic wave corresponding to the reference signal; and

means for concentrating the surface acoustic wave, provided at least in either space between said first or second input transducer and said waveguide to concentrate a surface acoustic wave generated by said input transducer so as to couple said wave with the waveguide;

wherein at least one of said means for concentrating the surface acoustic wave is arranged such that an angle of propagation of a component of surface acoustic wave bent by said means is within a range of an aperture angle of said waveguide.

Further, the invention provides a communication system comprising:

a transmitter for transmitting a signal modulated according to information; and

a receiver comprising:

a code generator for generating a reference signal;

a surface acoustic wave element for outputting a convolution signal of a received signal and the reference signal; and

a circuit for demodulating data using the convolution signal output from the surface acoustic wave element;

wherein said surface acoustic wave element comprises:

a piezoelectric substrate;

a waveguide provided on said piezoelectric substrate, for guiding a surface acoustic wave therethrough; and

a first input transducer provided on said piezoelectric substrate to generate a first surface acoustic wave corresponding to the received signal, and a second input transducer for generating a second surface acoustic wave corresponding to the reference signal,

wherein at least one of said first and second input transducers is arranged to concentrate a generated surface acoustic wave so as to couple said wave to the waveguide and to oscillate a surface acoustic wave in a range of an aperture angle of said waveguide.

Further, the invention provides a communication system comprising:

a transmitter for transmitting a signal modulated according to information; and

a receiver comprising:

a code generator for generating a reference signal;

a surface acoustic wave element for outputting a convolution signal of a received signal and the reference signal; and

a circuit for demodulating date using the convolution signal output form the surface acoustic wave element;

wherein said surface acoustic wave element comprises:

a piezoelectric substrate;

a waveguide provided on said piezoelectric substrate, for guiding a surface acoustic wave therethrough;

a first input transducer provided on said piezoelectric substrate to generate a first surface acoustic wave corresponding to the received signal, and a second input transducer for generating a second surface acoustic wave corresponding to the reference signal; and

means for concentrating the surface acoustic wave, provided at least in either space between said first or second input transducer and said waveguide to concentrate a surface acoustic wave generated by said input transducer so as to couple said wave with the waveguide;

wherein at least one of said means for concentrating the surface acoustic wave is arranged such that an angle of propagation of a component of surface acoustic wave bent by said means is within a range of an aperture angle of said waveguide.

## BRIEF DESCRIPTION OF THE DRAWINGS

Fig. 1 is a schematic drawing to show an example of a conventional surface acoustic wave element;

Fig. 2 is a constitutional drawing to show a surface acoustic wave element of Embodiment 1;

Fig. 3 is a partial enlarged drawing to show the SAW element of Embodiment 1;

Fig. 4 is a drawing to show the amplitude of surface acoustic wave generated by an input IDT;

Fig. 5 is a three-dimensional graph to show the amplitude of surface acoustic wave when the guided mode of waveguide is output from the end of waveguide;

Fig. 6 is a graph to show relations against waveguide width about the maximum of angle between the z axis and the direction normal to the wavefront of a SAW component propagating in waveguide, and a SAW-propagating direction of the component;

Fig. 7 is a three-dimensional graph to show the intensity of surface acoustic wave oscillated by an input IDT;

Fig. 8 is partial enlarged drawing to show a SAW element of Embodiment 2;

Fig. 9 is a drawing to show a structural example of input IDT from which surface acoustic waves spread out asymmetrically with respect to the waveguide direction;

Fig. 10 is a drawing to show an input IDT in double electrode structure;

Fig. 11 is a drawing to show a unidirectional input IDT;

Fig. 12 is a block diagram to show a communication system of Embodiment 3;

Fig. 13 is a block diagram to show a transmitter of Embodiment 4; and

Fig. 14 is a block diagram to show a receiver of Embodiment 4.

## DESCRIPTION OF THE PREFERRED EMBODIMENTS

Specific embodiments of the present invention will be described with reference to the accompanying drawings.

## Embodiment 1

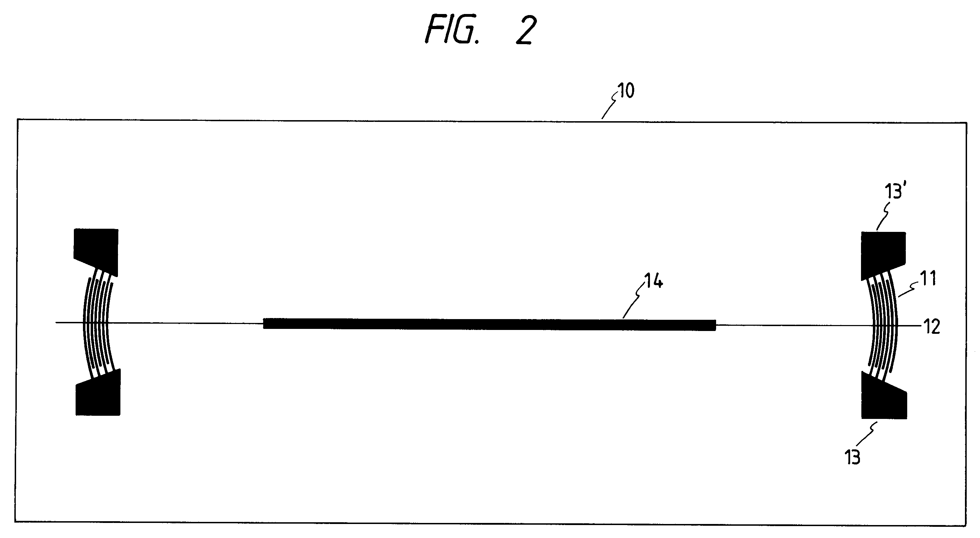

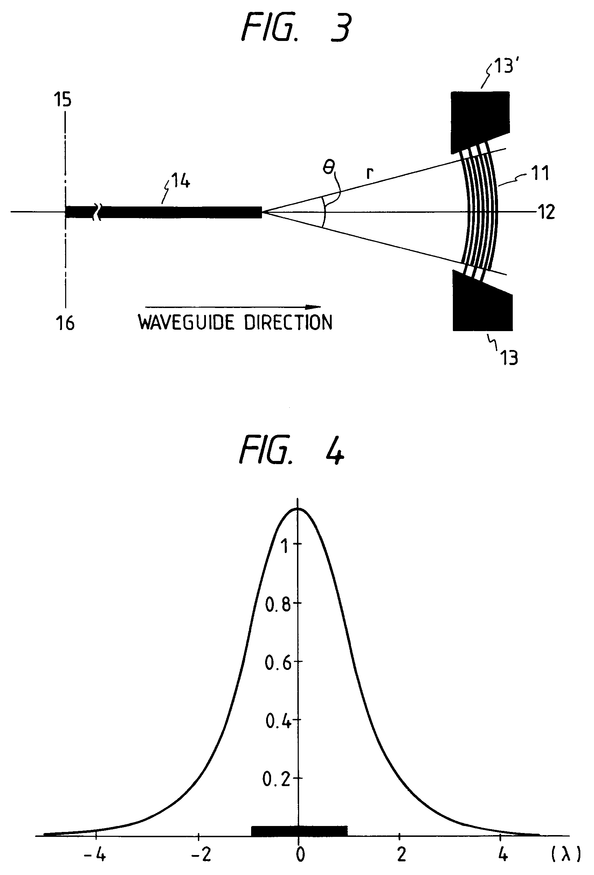

Fig. 2 is a constitutional drawing to show a SAW element such as a convolver in a first embodiment of the present invention. Reference numeral 10 denotes a piezoelectric substrate. Fig. 3 is a partial enlarged drawing of the element. In Fig. 3, 15-16 represents a center line of the element, and 12 the z axis of Y-cut lithium niobate. Numeral 14 denotes a waveguide, and $\theta$ an aperture angle of the waveguide 14. Numeral 11 denotes an input IDT for converting an electric signal into a surface acoustic wave. The input IDT 11 is concave toward the waveguide in order to concentrate the energy into the waveguide. Numerals 13, 13' are electrode pads. The width of waveguide 14 is determined within the range between the upper limit in which no higher transverse modes exist in order to prevent dispersion of propagation velocity due to the transverse modes and the lower limit in which no problem of attenuation is caused by velocity dispersion or leaky waves due to a difference in frequency in the desired frequency band. (In case of the SAW element of Y-cut Z-propagation lithium niobate, the width is in the range of 1.5 to 4λ.)

Incidentally, most of SAW elements utilize piezoelectric substrates changing the propagation velocity depending upon the propagation direction of surface acoustic wave (or having the velocity anisotropy). A native mode of surface acoustic wave propagating in a waveguide of metal thin film vapor-deposited on a piezoelectric substrate can be derived from a boundary condition between the metal vapor-deposited surface (electrically short surface) and a non-deposited surface (electrically open surface), which will be the amplitude intensity distribution as shown in Fig. 4. The native mode of SAW propagating in waveguide is precisely calculated for example in "KOSHIBA and SUZUKI, IECEJ Report (B), J61-B, p689(1978)." Also, the scalar potential approximation can be applied to calculation of native mode for Y-cut Z-propagation lithium niobate as in "R.V. Schmidt & L.A. Coldren, IEEE Transactions on sonics and ultrasonics, vol.su-22 No.2, March 1975, p.115-." Calculating the guided mode can obtain the maximum angle of wavefront of SAW which can propagate in waveguide.

Strictly speaking, the finite element method must be applied to calculation of a state in which the surface acoustic wave having the guided mode is output from the end of waveguide and is propagating on the piezoelectric substrate. It can be calculated more easily for example by considering anisotropy for the wave theory using the Huygens principle of SAW as in "J.B. Green et al., IEEE Transactions on sonics and ultrasonics, vol.30 No.1, January 1983, p.43-." The following formula (3) shows the result:

$$a = \int [\exp\{j(\omega t - k \cdot r)\}/r^{1/2}]d\sigma \qquad (3)$$

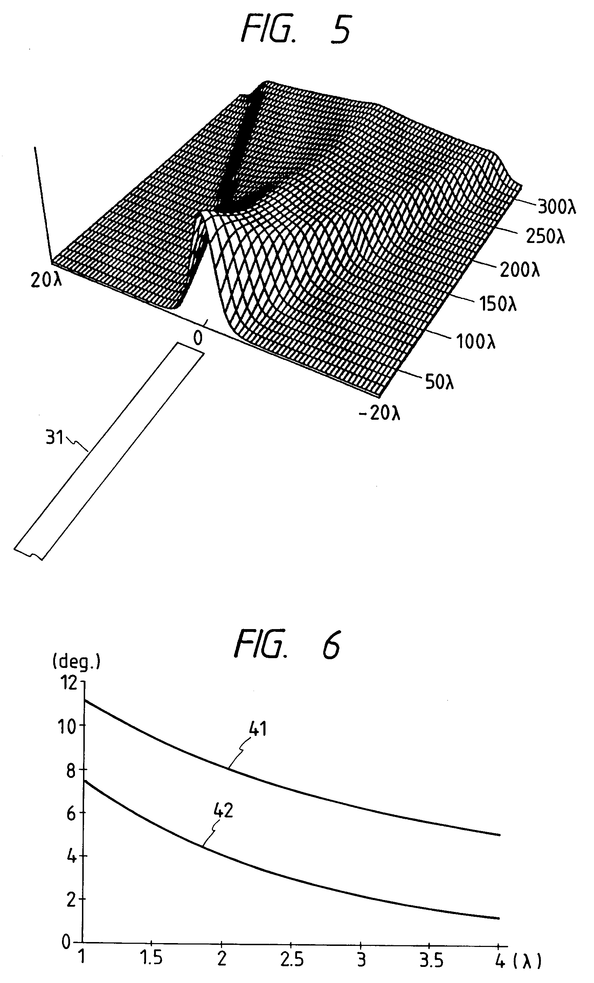

In the above formula, a represents a complex amplitude at a measurement point, $\omega$ an angular frequency of SAW, k a wave number, r a distance between an input interdigital electrode and the measurement point, and $d\sigma$ an infinitesimal interval of input electrode. The formula (3) calculates an influence of SAW output from the waveguide on the measurement point. Fig. 5 is a three-dimensional graph to show the amplitude intensity of SAW in case of the Y-cut Z-propagation lithium niobate when the guided mode of waveguide 31 in width of 2.5λ is output from the distal end of waveguide. The indication range of this graph is ±20λ in the x direction and 20λ to 320λ from the edge of waveguide 31 in the y direction. Fig. 6 is a graph to show relations between the waveguide width (λ) and, the maximum value 41 of angle (deg.) between the z axis and the direction normal to the wavefront of component of SAW propagating in waveguide, or the direction 42 (a half of aperture angle: deg.) of SAW propagation of this component. From this graph, the maximum angle is about 7 degrees between the z axis and the direction normal to the wavefront of SAW component propagating in waveguide of width 2.5λ. Assuming that the aperture angle of waveguide is a double of angle of propagation after the SAW of this component is output from the waveguide, the aperture angle is about 6 degrees.

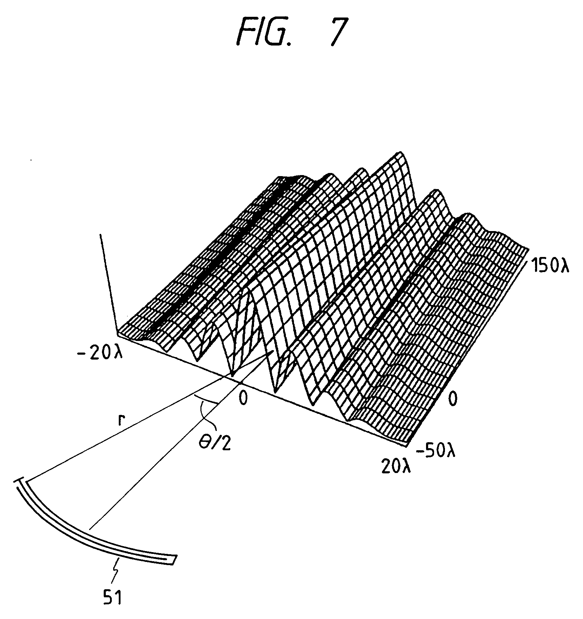

The input IDT of Fig. 3 is so arranged as to oscillate a surface acoustic wave matching with this aperture angle of waveguide. In the present embodiment the waveguide direction coincides with the direction of the z axis, which is the direction of a line connecting between the center of input interdigital electrode and the waveguide. The electric impedance of input IDT is proportional to the length of overlapping portions of paired electrodes, and the number of pairs in electrodes is proportional to the band width. Therefore, the length of electrodes is determined uniquely. The length of electrodes in Fig. 3 is determined in the manner as described above. Fig. 7 is a three-dimensional graph to show an amplitude intensity distribution of SAW oscillated by the input IDT as calculated in the above manner. In Fig. 7, numeral 51 designates an input IDT, which has a radius of curvature of r = 382λ and a central angle of $\theta = 6.0°$. An arc-shaped IDT with a radius of curvature of r = 83λ and a central angle of $\theta = 28.0°$ was also formed without considering the aperture angle. The arc-shaped IDT showed a coupling efficiency of about -10 dB for SAW oscillated thereby into a waveguide in width of 2.5λ, whereas the coupling efficiency of the input IDT of the present invention was about -6 dB.

Embodiment 2

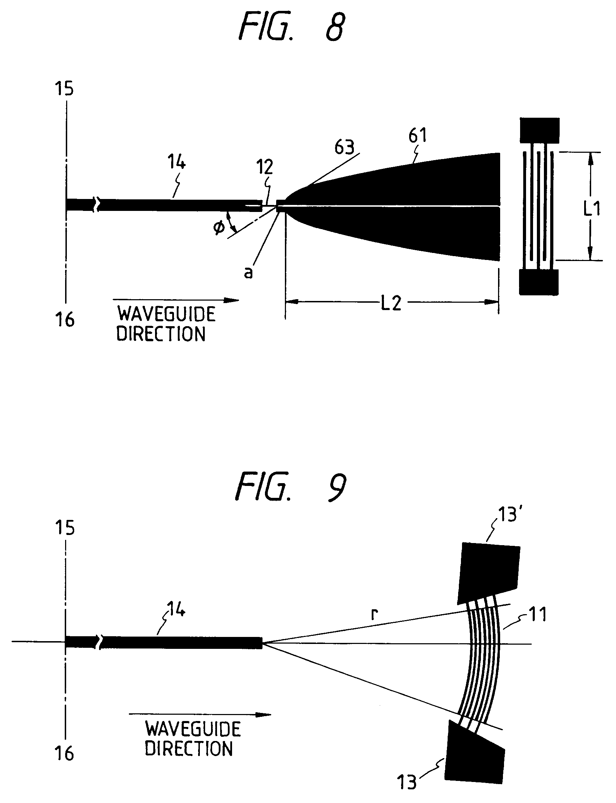

Fig. 8 is a partial enlarged drawing to show a SAW element according to the present invention. Fig. 8 shows a portion of substrate as enlarged similarly as Fig. 3, and the same elements as those in Fig. 3 are denoted by the same reference numerals in Fig. 8. The boundary of horn 61 is parabolic in case of an isotropic piezoelectric substrate, whereas it is pseudo-parabolic in case of an anisotropic substrate, considering the anisotropy of piezoelectric substrate so as to concentrate SAW at point a. Also, in case of the Y-cut Z-propagation lithium niobate in width of waveguide of 2.5λ, the maximum of angle $\phi$ between the horn and the z axis (a tangent line to that portion of horn 61 is shown by 63 in Fig. 8) is about 3°. In this case, if the width L1 of pseudo-parabolic horn (equal to the size of input interdigital electrode) is 40λ, the length L2 of the horn is about 3050λ in the direction of the z axis. Using this horn, the rate (coupling efficiency), at which SAW oscillated by the input IDT and propagating toward the waveguide 14 is guided into the waveguide, is at least 80%.

It should be noted that the calculation method as described in the above embodiment is an example and the present invention is not limited to the example. Other calculation methods may be applied.

Further, although the above embodiments showed examples in which the piezoelectric substrate was the Y-cut Z-propagation lithium niobate substrate, the substrate may have another cut or propagation direction, or may be another material. If the propagation directions of SAW output from the waveguide are not symmetric with respect to the waveguide direction, the input IDT should be formed to match with the angle of divergence as shown in Fig. 9.

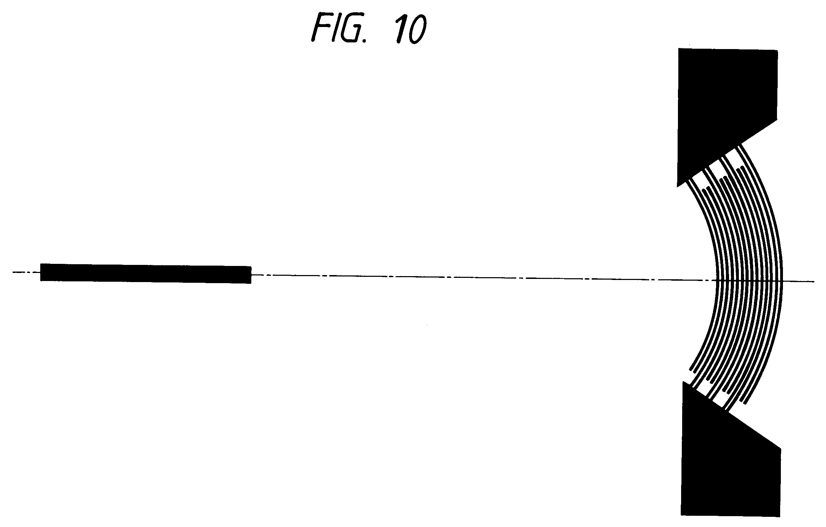

Also, the present invention can employ an input IDT in double electrode structure as shown in Fig. 10 in order to suppress reflection of SAW in electrode.

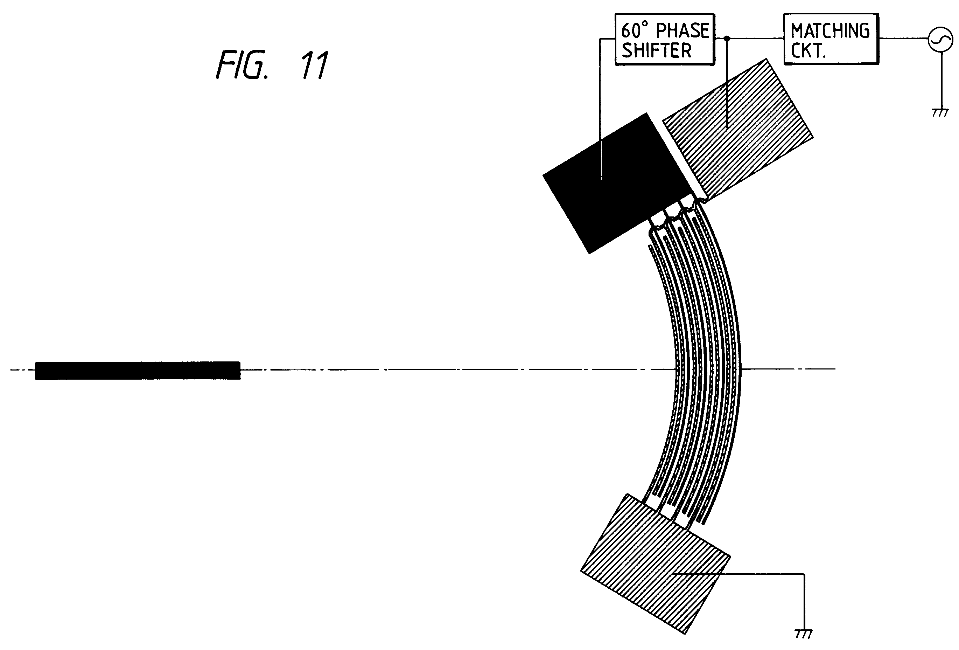

Further, the input IDT of the present invention may be a so-called unidirectional IDT, for example one to which three or more phase electric signal is input and which oscillates SAW only in one direction. Fig. 11 shows a three-phase unidirectional IDT.

Embodiment 3

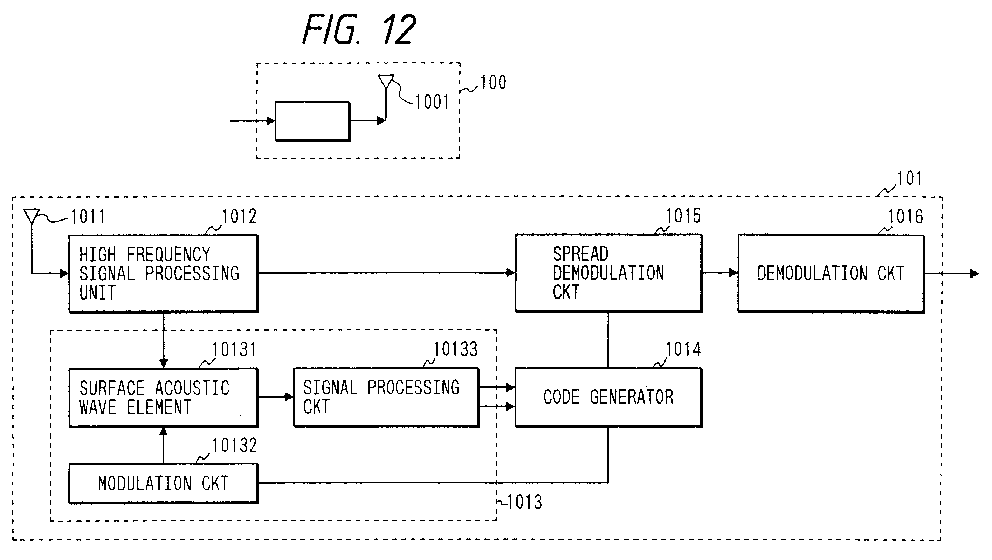

Fig. 12 is a block diagram to show an example of communication system using the SAW device as described above. In Fig. 12, reference numeral 100 designates a transmitter. The transmitter spread-spectrum-modulates a signal to be transmitted using spread codes and transmits the modulated signal through an antenna 1001. The transmitted signal is received by a receiver 101 and demodulated thereby. The receiver 101 is composed of an antenna 1011, a high frequency signal processing unit 1012, a synchronous circuit 1013, a code generator 1014, a spread demodulation circuit 1015, and a demodulation circuit 1016. A signal received through the antenna 1011 is properly filtered and amplified in the high frequency signal processing unit 1012 to be output as a signal in the transmission frequency band or as a converted a signal in a proper intermediate frequency band. The output signal is input into the synchronous circuit 1013. The synchronous circuit 1013 is composed of a SAW device 10131 as described in the preceding embodiments of the present invention, a modulation circuit 10132 for modulating a reference spread code supplied from the code generator 1014, and a signal processing circuit 10133 for processing the signal output from the SAW device 10131 and outputting a spread code synchronizing signal and a clock synchronising signal for the transmitted signal to the code generator 1014. Input into the SAW device 10131 are an output signal from the high frequency signal processing unit 1012 and an output signal from the modulation circuit 10132, to execute the convolution operation of the two input signals. Supposing the reference spread code supplied from the code generator 1014 to the modulation circuit 10132 is a time-inverted code of the spread code transmitted from the transmitter, a correlation peak is output from the SAW device 10131 when a synchronization-only spread code component included in the received signal and the reference spread code coincide with each other on the waveguide of SAW device 10131. The signal processing circuit 10133 detects the correlation peak from the signal received from the SAW device 10131, obtains an amount of deviation of code synchronization from a time of from the code start of the reference spread code to the output of correlation peak, and outputs the code synchronizing signal and the clock signal to the code generator 1014. After synchronization is established, the code generator 1014 generates spread codes coincident in clock and spread code phase with the transmission-side spread codes. The spread codes are input into the spread demodulation circuit 1015, which restores the signal before the spread modulation. Since the signal output from the spread demodulation circuit 1015 is a signal modulated by a popularly used modulation method such as the so-called frequency modulation or phase modulation, it can be demodulated by the demodulation circuit 1016, which is one well known by those who skilled in the art.

Embodiment 4

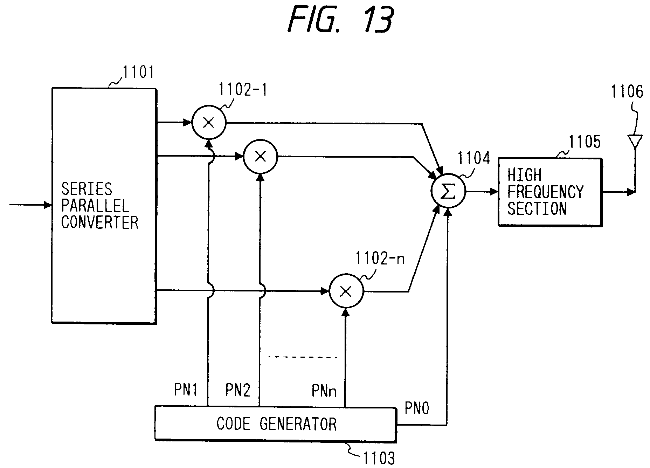

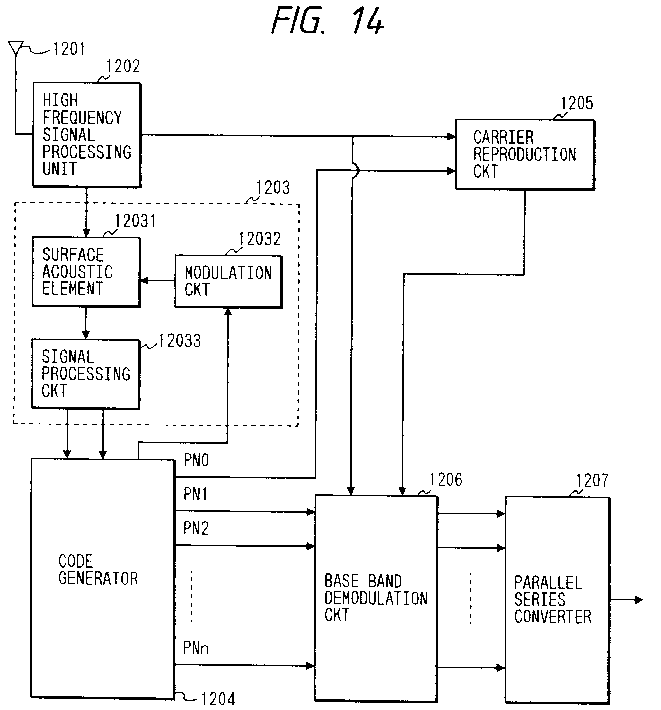

Fig. 13 and Fig. 14 are block diagrams to show an example of a transmitter and a receiver in a communication system employing the SAW device as described above. The present embodiment employs the CDM (Code division multiplexing) method as the communication method. In Fig. 13, numeral 1101 denotes a serial-parallel converter for converting serial input data into n pieces of parallel data, 1102-1 to 1102-n multipliers for multiplying the parallel data pieces by n spread codes output from the spread code generator, 1103 a spread code generator for generating n mutually different spread codes and a synchronization-only spread code, 1104 an adder for summing up the synchronization-only spread code output from the spread code generator 1103 and n outputs from the multipliers 1102-1 to 1102-n, 1105 a high frequency section for converting an output from the adder 1104 into a transmission frequency signal, and 1106 a transmission antenna. Further, in Fig. 14, numeral 1201 is a receiving antenna, 1202 a high frequency signal processing unit, 1203 a synchronous circuit for capturing and maintaining synchronization to transmission-side spread codes and clocks, 1204 a spread code generator for generating $n + 1$ spread codes and reference spread code same as the transmission-side spread codes, based on the code synchronizing signal and clock signal supplied from the synchronous circuit 1203, 1205 a carrier reproduction circuit for reproducing a carrier signal from a carrier reproduction spread code output from the spread code generator 1204 and an output from the high frequency signal processing unit 1202, 1206 a base band demodulation circuit for demodulating the signal in the base band, using an output from the carrier reproduction circuit 1205, an output from the high frequency signal processing unit 1202, and n spread codes of outputs from the spread code generator 1204, and 1207 a parallel-serial converter for parallel-to-serial-converting the n parallel demodulated data of outputs from the base band demodulation circuit 1206 into serial data.

In the above arrangement, input data is first converted by the serial-parallel converter 1101 into parallel data of n pieces equal to the code division multiplexing number in the transmitter. On the other hand, the spread code generator 1103 generates $n+1$ mutually different spread codes PN0 to PNn at a same code cycle. Among them, PN0 is only for synchronization and carrier reproduction, which is supplied directly to the adder 1104 without being modulated by the parallel data. The n rest spread codes are modulated by the n parallel data in the multipliers 1102-1 to 1102-n, and the modulated data is input into the adder 1104. The adder 1104 linearly sums up the $n+1$ signals input thereinto and outputs the sum as a base band signal to the high frequency section 1105. The high frequency section 1105 then converts the base band signal into a high frequency signal with a proper center frequency and transmits it through the transmission antenna 1106. In the receiver, the signal received through the receiving antenna 1201 is properly filtered and amplified in the high frequency signal processing unit 1202 to be output as a signal in the transmission frequency band or as a converted signal in a suitable intermediate frequency band. The signal is input into the synchronous circuit 1203. The synchronous circuit 1203 is composed of a SAW device 12031 as described in the previous embodiments of the present invention, a modulation circuit 12032 for modulating the reference spread code supplied from the code generator 1204, and a signal processing circuit 12033 for processing a signal output from the SAW device 12031 and outputting a spread code synchronizing signal and a clock synchronizing signal for transmitted signal to the spread-code generator 1204. An output signal from the high frequency signal processing unit 1202 and an output signal from the modulation circuit 12032 are input into the SAW device 12031, which executes a convolution operation of the two input signals. Supposing the reference spread code supplied from the code generator 1204 to the modulation circuit 12032 is a time-inverted code of the synchronization-only spread code transmitted from the transmitter, a correlation peak is output from the SAW device 12031 when the synchronization-only spread code component included in the received signal and the reference spread code coincide with each other on the waveguide in the SAW device 12031. The signal processing circuit 12033 detects the correlation peak from the signal supplied from the SAW device 12031, obtains an amount of deviation of code synchronization from the time between the code start of the reference spread code and the correlation peak output, and outputs a code synchronizing signal and a clock signal to the spread code generator 1204. After synchronization is established, the spread code generator 1204 generates spread codes coincident in clock and spread code phase with the transmission-side spread codes. Among these codes, the synchronization-only spread code PN0 is supplied to a carrier reproduction circuit 1205. The carrier reproduction circuit 1205 inversely spreads the received signal, which is an output from the high frequency signal processing unit 1202, in the transmission frequency band or in the intermediate frequency band if converted, with the synchronisation-only spread code PN0, to reproduce the carrier waves in the transmission frequency band or in the intermediate frequency band. The carrier reproduction circuit 1205 may be arranged as a circuit utilizing the phase-lock loop, for example. A multiplier multiplies the received signal by the synchronization-only spread code PN0. After synchronization is achieved, the synchronization-only spread code in the received signal is coincident in clock and code phase with the reference synchronization-only spread code. Since the transmission-side synchronization-only spread code was not modulated by data, it is inversely spread by the multiplier and a carrier component appears in an output from the multiplier. The output is then input into a band-pass filter to extract only the carrier component. The carrier component is output from the filter. The output is next input into a well-known phase-lock loop composed of a phase detector, a loop filer and a voltage control oscillator. The voltage control oscillator outputs as a reproduced carrier a signal phase-locked with the carrier component output from the band-pass filter. The reproduced carrier is supplied to the base band demodulation circuit 1206. The base band demodulation circuit produces a base band signal from the reproduced carrier and the output from the high frequency signal processing unit 1202. The base band signal is distributed to n channels and inversely spread by the spread codes PN1 to Pnn of outputs from the spread code generator 1204 every code division channel. Subsequently, data is demodulated. The parallel demodulated data of n pieces is converted into serial data by the parallel-serial convertor 1207, and the serial data is then output.

Using the CDM method as communication method, a plurality of data can be transmitted in bundle, which can increase a transmission capacity.

Also, the present embodiment showed an example of bi-level modulation, but may employ the orthogonal modulation or other modulation methods.

As described above, the present invention can achieve a high coupling efficiency by obtaining the guided mode from the boundary condition of waveguide, calculating the aperture angle from the guided mode, and arranging as to guide the SAW into the waveguide within the range of aperture angle. Especially in case of the convolver utilizing the physical nonlinear effect, an improvement in coupling efficiency between the waveguide and the input transducer is magnificent, because the output is proportional to the product of two surface acoustic waves and the output efficiency is proportional to the square of the coupling efficiency between the both ends of waveguide (output electrode) and the input transducer.

Also, the communication system using the SAW device of the present invention can perform high-quality transmission.

A surface acoustic wave element includes a piezoelectric substrate, a waveguide provided on the piezoelectric substrate to guide a surface acoustic wave therethrough, and an input transducer provided on said piezoelectric substrate to generate the surface acoustic wave. The input transducer is arranged to concentrate the surface acoustic wave so as to couple it with the waveguide and to oscillate the surface acoustic wave within a range of an aperture angle of the waveguide.

**Claims**

1. A surface acoustic wave element comprising:

    a piezoelectric substrate;

    a waveguide provided on said piezoelectric substrate, for guiding a surface acoustic wave therethrough; and

    an input transducer provided on said piezoelectric substrate, for generating the surface acoustic wave, wherein said input transducer is arranged to concentrate the generated surface acoustic wave so as to couple the surface acoustic wave with said waveguide, and to oscillate the surface acoustic waves within a range of an aperture angle of said waveguide.

2. A surface acoustic wave element according to Claim 1, wherein said piezoelectric substrate has velocity anisotropy.

3. A surface acoustic wave element according to Claim 1, wherein said input transducer is an interdigital electrode.

4. A surface acoustic wave element according to Claim 3, wherein said interdigital electrode is concave toward said waveguide.

5. A surface acoustic wave element comprising:

    a piezoelectric substrate;

    a waveguide provided on said piezoelectric substrate, for guiding a surface acoustic wave therethrough; and

    an input transducer provided on said piezoelectric substrate, for generating the surface acoustic wave, wherein said input transducer is an interdigital electrode the shape of which is concave toward said waveguide, and wherein a maximum value of angle between a normal line to said interdigital electrode and a waveguide direction is arranged within an angle between the waveguide direction and a normal line to a wavefront of a surface acoustic wave output from the waveguide, propagating on the piezoelectric substrate, and having a maximum angle of direction of phase velocity relative to the waveguide direction among surface acoustic waves which can propagate in said waveguide.

6. A surface acoustic wave element according to Claim 5, wherein said piezoelectric substrate has velocity anisotropy.

7. A surface acoustic wave element comprising:

    a piezoelectric substrate;

    a waveguide provided on said piezoelectric substrate, for guiding a surface acoustic wave therethrough;

    an input transducer provided on said piezoelectric substrate, for generating the surface acoustic wave; and

    means for concentrating the surface acoustic wave, provided between said input transducer and said waveguide to concentrate the surface acoustic wave generated by the input transducer so as to couple said wave with the waveguide, wherein said means is arranged such that an angle of propagation of a component in a surface acoustic wave bent by said means is within a range of an aperture angel of said waveguide.

**8.** A surface acoustic wave element according to Claim 7, wherein said piezoelectric substrate has velocity anisotropy.

**9.** A surface acoustic wave element according to Claim 7, wherein said input transducer is an interdigital electrode.

**10.** A surface acoustic wave element comprising:

a piezoelectric substrate;

a waveguide provided on said piezoelectric substrate, for guiding a surface acoustic wave therethrough;

an input transducer provided on said piezoelectric substrate, for generating the surface acoustic wave; and

means for concentrating the surface acoustic wave, provided between said input transducer and said waveguide to concentrate the surface acoustic wave generated by the input transducer so as to couple said wave with the waveguide, wherein said means is arranged such that a maximum value of an angle between a waveguide direction and a normal line to a wavefront of a surface acoustic wave a direction of which is changed by said means is within an angle between the waveguide direction and a normal line to a wavefront of a surface acoustic wave output from the waveguide and propagating on the piezoelectric substrate, with a maximum angle of direction of phase velocity relative to the waveguide direction among surface acoustic waves which can propagate in said waveguide.

**11.** A surface acoustic wave element according to Claim 10, wherein said piezoelectric substrate has velocity anisotropy.

**12.** A surface acoustic wave element according to Claim 10, wherein said input transducer is an interdigital electrode.

**13.** A surface acoustic wave element according to Claim 1, wherein an impedance of said input transducer is matched with an impedance of an input circuit into said input transducer.

**14.** A surface acoustic wave element according to Claim 3, wherein said interdigital electrode is arranged in double electrode structure.

**15.** A surface acoustic wave element according to Claim 3, wherein said interdigital electrode is unidirectional.

**16.** A method for designing an input transducer for a surface acoustic wave element in which the input transducer is provided on a piezoelectric substrate to generate a surface acoustic wave and to concentrate said surface acoustic wave so as to couple said wave with a waveguide, comprising steps of:

obtaining a guided mode of said waveguide;

calculating a maximum angle of divergence when said guided mode is output from said waveguide; and

determining a shape of the input transducer such that a surface acoustic wave is oscillated within a range of said maximum angle of divergence and that said surface acoustic wave is concentrated to be coupled with the waveguide.

**17.** A method according to Claim 16, wherein the guided mode is obtained from a boundary condition of waveguide.

**18.** A method for designing means for concentrating a surface acoustic wave in a surface acoustic wave element in which an input transducer is provided on a piezoelectric substrate to generate a surface acoustic wave and said surface acoustic wave is guided to a waveguide through the means for concentrating the surface acoustic wave, comprising steps of:

obtaining a guided mode of said waveguide;

calculating a maximum angle of divergence when said guided mode is output from said waveguide; and

determining a shape of the means for concentrating the surface acoustic wave such that a surface acoustic wave output from the means for concentrating the surface acoustic wave is within a range of said maximum angle of divergence.

19. A method according to Claim 18, wherein said guided mode is obtained from a boundary condition of the waveguide.

20. A signal receiver comprising:
a code generator for generating a reference signal;
a surface acoustic wave element for outputting a convolution signal of a received signal and the reference signal; and
a circuit for demodulating data using the convolution signal output from the surface acoustic wave element;
wherein said surface acoustic wave element comprises:
a piezoelectric substrate;
a waveguide provided on said piezoelectric substrate, for guiding a surface acoustic wave therethrough; and
a first input transducer provided on said piezoelectric substrate to generate a first surface acoustic wave corresponding to the received signal, and a second input transducer for generating a second surface acoustic wave corresponding to the reference signal; and
wherein at least one of said first and second input transducers is arranged to concentrate a generated surface acoustic wave so as to couple said wave with the waveguide and to oscillate a surface acoustic wave in a range of an aperture angle of said waveguide.

21. A signal receiver comprising:
a code generator for generating a reference signal;
a surface acoustic wave element for outputting a convolution signal of a received signal and the reference signal; and
a circuit for demodulating date using the convolution signal output form the surface acoustic wave element;
wherein said surface acoustic wave element comprises:
a piezoelectric substrate;
a waveguide provided on said piezoelectric substrate, for guiding a surface acoustic wave therethrough;
a first input transducer provided on said piezoelectric substrate to generate a first surface acoustic wave corresponding to the received signal, and a second input transducer for generating a second surface acoustic wave corresponding to the reference signal; and
means for concentrating the surface acoustic wave, provided at least in either space between said first or second input transducer and said waveguide to concentrate a surface acoustic wave generated by said input transducer so as to couple said wave with the waveguide;
wherein at least one of said means for concentrating the surface acoustic wave is arranged such that an angle of propagation of a component of surface acoustic wave bent by said means is within a range of an aperture angle of said waveguide.

22. A communication system comprising:
a transmitter for transmitting a signal modulated according to information; and
a receiver comprising:
a code generator for generating a reference signal;
a surface acoustic wave element for outputting a convolution signal of a received signal and the reference signal; and
a circuit for demodulating data using the convolution signal output from the surface acoustic wave element;
wherein said surface acoustic wave element comprises:
a piezoelectric substrate;
a waveguide provided on said piezoelectric substrate, for guiding a surface acoustic wave therethrough; and
a first input transducer provided on said piezoelectric substrate to generate a first surface acoustic wave corresponding to the received signal, and a second input transducer for generating a second surface acoustic wave corresponding to the reference signal,

wherein at least one of said first and second input transducers is arranged to concentrate a generated surface acoustic wave so as to couple said wave to the waveguide and to oscillate a surface acoustic wave in a range of an aperture angle of said waveguide.

23. A communication system according to Claim 22, wherein a communication method is CDM (Code Division Multiplexing).

24. A communication system comprising:
a transmitter for transmitting a signal modulated according to information; and
a receiver comprising:
a code generator for generating a reference signal;
a surface acoustic wave element for outputting a convolution signal of a received signal and the reference signal; and
a circuit for demodulating date using the convolution signal output form the surface acoustic wave element;
wherein said surface acoustic wave element comprises:
a piezoelectric substrate;
a waveguide provided on said piezoelectric substrate, for guiding a surface acoustic wave therethrough;
a first input transducer provided on said piezoelectric substrate to generate a first surface acoustic wave corresponding to the received signal, and a second input transducer for generating a second surface acoustic wave corresponding to the reference signal; and
means for concentrating the surface acoustic wave, provided at least in either space between said first or second input transducer and said waveguide to concentrate a surface acoustic wave generated by said input transducer so as to couple said wave with the waveguide;
wherein at least one of said means for concentrating the surface acoustic wave is arranged such that an angle of propagation of a component of surface acoustic wave bent by said means is within a range of an aperture angle of said waveguide.

25. A communication system according to Claim 24, wherein a communication method is CDM (Code division multiplexing).

# FIG. 1
# PRIOR ART

FIG. 2

EP 0 617 510 A1

# FIG. 3

# FIG. 4

# FIG. 5

# FIG. 6

# FIG. 7

FIG. 8

FIG. 9

FIG. 10

FIG. 11

## FIG. 12

EP 0 617 510 A1

# FIG. 13

EP 0 617 510 A1

## FIG. 14

25

<table>
<tr><td colspan="4"><strong>European Patent Office</strong>     <strong>EUROPEAN SEARCH REPORT</strong>     Application Number<br>EP 94 10 4438</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| D,X | IEEE TRANSACTIONS ON SONICS AND ULTRASONICS, vol.30, no.1, January 1983, NEW YORK US pages 43 - 50 J.B. GREEN ET AL. 'SAW convolvers using focused interdigital transducers' * page 43, left column, line 21 - right column, line 10; figures 1,5 * | 1-6, 16-19 | H03H9/42 G06G7/195 |
| D,Y | --- | 13-15,20 | |
| X | MICROWAVE JOURNAL, vol.28, no.7, July 1985, DEDHAM US pages 169 - 177 H.P. GRASSL 'SAW convolvers for matched filtering' * page 175, left column, line 3 - right column, line 9; figure 7 * | 7-12 | |
| Y | --- | 13 | |
| Y | JAPANESE JOURNAL OF APPLIED PHYSICS, SUPPLEMENTS, vol.26, no.26-1, 1987, TOKYO JA pages 132 - 134 Y. FUJITA ET AL. 'A new unidirectional SAW transducer with a simplified external network' * figure 1 * | 14,15 | TECHNICAL FIELDS SEARCHED (Int.Cl.5) H03H G06G |
| | --- <br> -/-- | | |

The present search report has been drawn up for all claims

| Place of search | Date of completion of the search | Examiner |
|---|---|---|
| THE HAGUE | 4 July 1994 | Den Otter, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | 7TH EUROPEAN CONFERENCE ON ELECTROTECHNICS - EUROCON 86;21-23 april 1986,Paris,FR IEEE,New York,US,1986 pages 632-636 M. KOWATSCH et al.:"Spread-spectrum signal processing with surface acoustic wave convolvers" *page 633,left column,lines 39-53;figures 1,2,5* | 21-25 | |
| Y | | 20 | |
| A | PATENT ABSTRACTS OF JAPAN vol. 13, no. 254 (E-772) 13 June 1989 & JP-A-01 051 837 (NEC CORP) 28 February 1989 * abstract * | 23,25 | |
| | | | TECHNICAL FIELDS SEARCHED (Int.Cl.5) |

The present search report has been drawn up for all claims

| Place of search | Date of completion of the search | Examiner |
|---|---|---|
| THE HAGUE | 4 July 1994 | Den Otter, A |